# EUROPÄISCHE PATENTANMELDUNG

(11) **EP 0 870 789 A1**
(43) Veröffentlichungstag der Anmeldung: **14.10.1998**
(21) Anmeldenummer: 98106284.7
(22) Anmeldetag: 06.04.1998
(51) Int. Cl.: C08G 18/67, C09D 175/14, G03F 7/035

(54) **Aminogruppen tragende Polyurethane**

(30) Priorität: 08.04.1997 DE 19714514
(71) Anmelder: BASF AKTIENGESELLSCHAFT, 67056 Ludwigshafen (DE)
(72) Erfinder: Kokel, Nicolas, Dr., 67069 Ludwigshafen (DE); Ganss, Helmut, 67067 Ludwigshafen (DE); Wegener, Stefan, Dr., 55124 Mainz (DE)
(74) Vertreter: Isenbruck, Günter, Dr.

(57) **Zusammenfassung**

Beschrieben ist ein Polyurethan, erhältlich durch Umsetzung eines Reaktionsgemischs, mindestens enthaltend
a) ein im wesentlichen von NCO-Gruppen freies Polyurethan mit mindestens einer olefinisch ungesättigten Doppelbindung und
b) Ammoniak oder wenigstens ein primäres Amin oder wenigstens ein sekundäres Amin oder ein Gemisch aus zwei oder mehr davon.

Im Polyurethan ist das molare Verhältnis von olefinisch ungesättigten Doppelbindungen zu aciden, von Ammoniak oder Aminen stammenden Wasserstoffatomen im Reaktionsgemisch größer als 10:8. Beschrieben ist auch seine Verwendung in photopolymeren Druckplatten.

## Beschreibung

Die Erfindung betrifft Aminogruppen tragende Polyurethane, ein Verfahren zur Herstellung solcher Polyurethane, deren Verwendung, Beschichtungsmittelzusammensetzungen die solche Aminogruppen tragenden Polyurethane enthalten sowie Photodruckplatten, die solche Aminogruppen tragenden Polyurethane enthalten.

Es ist seit langem ein Bestreben, auf einfache Art und Weise Aminogruppen in Polyurethane einzuführen. Derart funktionalisierte Polyurethane verfügen über eine Reihe von Eigenschaften, die bei der Verwendung solcher Polyurethane in der Beschichtungsmittelindustrie vorteilhaft sind.

So läßt sich z.B. bei Anwesenheit primärer oder sekundärer Aminogruppen eine einfache Vernetzung des Polyurethans, beispielsweise durch Zugabe mindestens difunktioneller, mit primären oder sekundären Aminogruppen reaktiven Vernetzern (wie beispielsweise Polyisocyanaten) erreichen.

Ein weiterer Vorteil von Aminogruppen in Polyurethanen besteht in der Möglichkeit, die Polyurethane durch Neutralisierung oder Quaternisierung zu hydrophilieren. Die Neutralisierung kann sowohl mit primären als auch mit sekundären oder tertiären Aminogruppen durchgeführt werden und wird beispielsweise durch die Zugabe von Säuren zu aminogruppenhaltigen Polyurethanen erreicht. Hierzu kommen Mineralsäuren, wie beispielsweise Salzsäure oder Schwefelsäure, aber auch organische Carbonsäuren, wie beispielsweise Ameisensäure oder Essigsäure in Frage. Eine Möglichkeit zur Quaternisierung von Aminogruppen stellt die Alkylierung dar. Hierbei werden die freien, bevorzugt tertiären Aminogruppen mit einem Alkylierungsmittel umgesetzt. Beim Alkylierungsmittel handelt es sich in der Regel um ein Alkyl- oder Benzylhalogenid, das mit dem vorzugsweise tertiären Amin unter Ausbildung einer quaternisierten Aminogruppe reagiert.

In Rahmen des vorliegenden Textes werden der Einfachheit halber die Begriffe *"Quaternisierung"* und *"quaternisiert"* sowohl für das mittels Säuren neutralisierte Stickstoffatom bzw. den dazugehörigen Neutralisationsvorgang als auch für das alkylierte Stickstoffatom bzw die Alkylierung gebraucht.

Polyurethane, die quaternisierte Amine enthalten, lassen sich in der Regel ab einem bestimmten Gehalt an quaternisierten Aminogruppen in Wasser lösen oder zumindest dispergieren. Die Wasserlöslichkeit bzw. Wasserdispergierbarkeit von Polyurethanen ist insbesondere unter ökologischen Gesichtspunkten außerordentlich wichtig. Werden solche Polyurethane beispielsweise als Bindemittel oder Bestandteil eines Gemischs aus einem oder mehreren Bindemitteln in Beschichtungsmittelzusammensetzungen verwendet, so kann der Einsatz von organischen Lösemitteln weitgehend vermieden werden. Dies stellt unter dem Aspekt der Umweltbelastung mit organischen Lösemitteln eine vorteilhafte Eigenschaft dar.

Unter *"Bindemitteln"* oder *"polymeren Bindemitteln"* werden im erfindungsgemäßen Sinne diejenigen polymeren Bestandteile einer Beschichtungsmittelzusammensetzung verstanden, die am Aufbau der trockenen Beschichtung beteiligt sind und der Beschichtung mechanische Stabilität verleihen.

Polyurethane mit tertiären Aminogruppen bieten jedoch noch andere, spezifischere Verwendungsmöglichkeiten. Insbesondere ist die Verwendung von tertiäre Aminogruppen enthaltenden Polyurethanen in photopolymerisierbaren Aufzeichnungsmaterialien, wie beispielsweise Reliefdruckplatten oder Photoresists, vorteilhaft.

So ist es beispielsweise bekannt, Reliefdruckplatten oder Photoresists auf photochemischem Wege herzustellen, indem man eine auf einem Schichtträger aufgebrachte strahlungshärtbare, insbesondere photopolymerisierbare, Schicht (Photoschicht) bildweise mittels einer Strahlungsquelle, insbesondere aktinischem Licht (s. z.B. Römpp Chemie Lexikon, 9. Aufl., S. 4804), belichtet. Die belichtete Photoschicht wird anschließend durch Behandeln mit einem Lösemittel entwickelt, in welchem die unbelichteten, nicht aber die belichteten Bereiche der Photoschicht löslich oder zumindest dispergierbar sind. Die Photoschicht enthält dabei im allgemeinen niedermolekulare strahlungshärtbare, insbesondere photopolymerisierbare Verbindungen, Photoinitiatoren sowie ein polymeres Bindemittel, welches gleichfalls der Photopolymerisation oder Photovernetzung zugänglich sein kann. Die Anforderungen, die an solche photopolymerisierbaren Aufzeichnungsmaterialien und insbesondere auch an das polymere Bindemittel der strahlungshärtbaren, bzw. photopolymerisierbaren Schicht gestellt werden, sind aus der einschlägigen Literatur bekannt.

Photopolymerisierbare Aufzeichnungsmaterialien, die als Bindemittel in der photopolymerisierbaren Schicht ein Polyurethan enthalten, haben sich in vielerlei Hinsicht insbesondere für den Druck mit Ölfarben als vorteilhaft erwiesen. So sind bereits vielfach für die Herstellung von Druckplatten geeignete, photopolymerisierbare Gemische im Stand der Technik beschrieben und dem Fachmann bekannt, die neben einem Photoinitiator und gegebenenfalls anderen photopolymerisierbaren Verbindungen ein Polyurethan oder ein Polyurethan-Prepolymerisat mit Doppelbindungen, insbesondere aktivierten Doppelbindungen, entweder am Kettenende, seitenständig zum Polymerrückgrat oder innerhalb des Polymerrückgrats eingebunden, enthalten.

Es ist dabei aus den oben erwähnten, ökologischen Gründen erstrebenswert, photopolymerisierbare Aufzeichnungsmaterialien zu entwickeln, die nicht nur hinreichende mechanische und drucktechnische Eigenschaften besitzen, sondern darüber hinaus in umweltfreundlichen Lösemitteln entwickelbar sind. Besonders vorteilhaft wirken sich wäßrige Lösemittel aufgrund der fehlenden oder zumindest verringerten Emission organischer Lösemittel bei der Herstellung und Anwendung solcher photopolymerisierbarer Aufzeichnungsmaterialien aus.

Der Stand der Technik nennt Vorschläge, wie sich Polyurethane, die photopolymerisierbare Doppelbindungen enthalten, durch Wasser oder zumindest wäßrige Medien entwickelbar gestalten lassen.

So beschreibt beispielsweise die EP 54 150 ein photopolymerisierbares Aufzeichnungsmaterial und Verfahren zur Herstellung von Reliefformen mittels dieses Aufzeichnungsmaterials. Hierbei wird in der photopolymerisierbaren Schicht ein im wesentlichen lineares, bei Raumtemperatur festes, hochmolekulares, thermoplastisches Polyurethan, das seitenständige photopolymerisierbare Doppelbindungen und quaternäre oder quaternisierbare Stickstoffatome oder quaternäre und quaternisierbare Stickstoffatome eingebaut enthält, als Bindemittel eingesetzt. Die genannten Stickstoffatome werden in das Polyurethan eingebaut, indem bei der Herstellung des Polyurethans tertiäre Stickstoffatome tragende Verbindungen mitverwendet werden, die im Sinne der Isocyanatchemie im allgemeinen wenigstens bifunktionell reaktionsfähig sind. Insbesondere werden Diole mit tertiären Stickstoffatomen, aber auch beispielsweise Diamine oder Aminoalkohole empfohlen. Die Einführung der tertiären Aminogruppe erfolgt demnach durch Reaktion einer entsprechenden gegenüber Isocyanaten in der Regel mindestens difunktionellen Verbindung mit den Isocyanatgruppen bei der Herstellung des Polyurethans oder mit dem Polyurethan Prepolymeren.

Die EP 584 970 A2 offenbart strahlungsvernetzbare Polymere und Zusammensetzungen oder solche Polymere enthaltende Zubereitungen sowie ein Verfahren zur Herstellung und zur Verwendung solcher Polymere. Die Druckschrift beschreibt ebenfalls die Herstellung von sowohl Doppelbindungen als auch tertiäre Aminogruppen tragenden Polyurethanen, wobei die Einführung der tertiären Aminogruppe gleichfalls durch Reaktion eines im Sinne der Isocyanatchemie mindestens difunktionellen Bausteins mit einer tertiären Aminogruppe (einem Dialkanolalkylamin) in die Polyurethankette erfolgt.

Die aus dem Stand der Technik bekannte Methode des Einführens von tertiären Aminogruppen in das Polyurethan durch Reaktion eines gegenüber Isocyanaten reaktive Gruppen tragenden, tertiären Amins, weist einige gravierende Nachteile auf. Die zwingende Anwesenheit eines Bausteins, der sowohl eine, vorzugsweise tertiäre, Aminogruppe und mindestens eine gegenüber Isocyanaten reaktionsfähige Gruppe aufweist, stellt eine bedeutende Einschränkung bei der Polyurethansynthese dar. Noch gravierendere Nachteile ergeben sich allerdings dadurch, daß durch die Einführung einer Aminogruppe in das isocyanatgruppenhaltige reaktive Milieu unerwünschte basenkatalysierte Nebenreaktionen der Isocyanatgruppen ablaufen können.

Eine erste Konsequenz solcher Nebenreaktionen besteht darin, daß meistens eine deutliche Erhöhung der Viskosität oder unter Umständen sogar eine Gelierung des Ansatzes stattfindet. Infolgedessen ist der Ansatz meist nur schwer weiter zu verarbeiten. Weiterhin fehlt, bedingt durch die Nebenreaktionen, ein Teil der Isocyanatgruppen bei der Umsetzung der H-aktiven Verbindungen mit den Isocyanatgruppen zur vollständigen Umsetzung in der stöchiometrischen Bilanz, so daß am Ende der Reaktion Gruppen mit aktiven H-Atomen nicht umgesetzt sind und dadurch die gewünschten Produkteigenschaften nicht zuverlässig und reproduzierbar erreicht werden können.

Diese basisch katalysierten Nebenreaktionen können durch Senkung der Umsetzungstemperatur weitgehend unterdrückt werden. Dabei verlängert sich aber die Reaktionsdauer zum Teil drastisch, wobei nicht gewährleistet werden kann, daß die Mehrheit der vorhandenen Gruppen mit aktiven H-Atomen sich an das Isocyanat addiert. Darüber hinaus kann eine Umsetzung bei niedriger Temperatur aufgrund von Viskositätsproblemen nur in der Anwesenheit von größeren Lösemittelmengen durchgeführt werden. Deren Verwendung ist jedoch aus ökologischen und ökonomischen Gründen, sowie aus Gründen der Arbeitssicherheit nicht erstrebenswert.

Die EP 401 898 B1 betrifft flüssige Beschichtungsmittelzusammensetzungen. Diese umfassen als Bindemittel eine Verbindung, die wenigstens zwei aktivierte, olefinisch ungesättigte Gruppen enthält sowie ein dort näher definiertes, monoprimäres Amin als Vernetzungsmittel für die aktivierten, olefinisch ungesättigten Gruppen des Bindemittels. Die primären Aminogruppen dienen als Vernetzer, wobei das Verhältnis von Doppelbindungen zu primären Aminogruppen (entsprechend zwei NH-Äquivalenten) in einem Bereich von 1,5 bis 2,5, vorzugsweise in einem Bereich von 1,9 bis 2,1 und besonders bevorzugt bei 2,0 liegt. Bei einer solchen Umsetzung werden zwar tertiäre Aminogruppen in ein polyurethanhaltiges System eingeführt, die Zahl der verbleibenden Doppelbindungen ist jedoch für eine photochemische Vernetzung nicht ausreichend. Außerdem ist der genannten Druckschrift kein Hinweis auf strahlungshärtbare Systeme zu entnehmen.

Die US 5,426,157 betrifft verbesserte Polyepoxidharze mit verbesserten physikalischen und elastischen Eigenschaften. Die Polyepoxidharze werden hergestellt, indem ein acrylatterminiertes Polyurethan sowie ein Polyepoxid mit einem Amin-Vernetzer umgesetzt werden, der zwei sekundäre Aminowasserstoffe aufweist. Auch diese Druckschrift bezieht sich lediglich auf die Vernetzung der darin enthaltenen Bindemittel durch das disekundäre Amin. Über verbleibende Anteile von zur Vernetzung durch Strahlung geeigneten Doppelbindungen wird keine Aussage gemacht.

Die Aufgabe der Einführung von tertiären Aminogruppen in strahlungshärtbare Systeme auf eine schonende Weise, die nicht zu einer Beeinträchtigung bei der Herstellung des Polyurethans führt, ist auf die bislang im Stand der Technik beschriebene Weise nicht zufriedenstellend gelöst worden.

Es bestand daher die Aufgabe, ein Verfahren zu entwickeln, das zum einen die Herstellung des tertiäre Aminogruppen tragenden Polyurethans gewährleistet, ohne daß die oben geschilderten Nachteile auftreten, und zudem das Einbringen von Aminogruppen, insbesondere tertiären Aminogruppen, in das Polyurethan signifikant erleichtert. Die Einführung der Aminogruppen in das Polyurethan muß immer unter der Prämisse geschehen, daß das Polyurethan - oder zumindest ein ein solches Polyurethan enthaltendes Gemisch - weiterhin die zur photochemischen Vernetzung erforderliche Reaktivität aufweist.

Überraschenderweise wurde nun gefunden, daß beliebige Polyurethane, die olefinisch ungesättigte Doppelbindungen enthalten, mit Ammoniak, primären Aminen oder sekundären Aminen unter Ausbildung tertiärer Aminogruppen umgesetzt werden können. Bei der Wahl einer geeigneten Stöchiometrie zwischen olefinisch ungesättigten Doppelbindungen und Aminogruppen entsteht so ein Polyurethan, welches die bislang bekannten Nachteile des Standes der Technik, wie beispielsweise lange Reaktionszeiten oder Gelierung des Ansatzes, nicht zeigt, sondern kurze Reaktionszeiten und eine im Vergleich zum Stand der Technik wesentlich breitere Auswahl an einsetzbaren Polyurethansystemen erlaubt.

Gegenstand der Erfindung ist daher ein Polyurethan, erhältlich durch Umsetzung eines Reaktionsgemischs, mindestens enthaltend
a) mindestens ein im wesentlichen von NCO-Gruppen freies Polyurethan mit mindestens einer olefinisch ungesättigten Doppelbindung und
b) Ammoniak oder mindestens ein primäres Amin oder mindestens ein sekundäres Amin oder ein Gemisch aus zwei oder mehr davon,
   dadurch gekennzeichnet, daß das molare Verhältnis von olefinisch ungesättigten Doppelbindungen zu aciden, von Ammoniak oder Amin oder Aminen stammenden Wasserstoffatomen im Reaktionsgemisch größer als 10 : 8 ist.

Unter *"Polyurethan"* werden im Sinne der Erfindung Verbindungen verstanden, die wenigstens zwei Urethangruppen pro Molekül aufweisen.

Alle nachfolgenden Angaben zu Prozenten oder Teilen sind als Gewichtsprozente oder Gewichtsteile zu verstehen, insofern keine anderslautenden Angaben gemacht sind.

Der Begriff *"im wesentlichen von NCO-Gruppen freies Polyurethan"* umfaßt solche Polyurethane, die keinen oder zumindest nur noch einen vernachlässigbar geringen Anteil an NCO-Gruppen aufweisen. Als vernachlässigbar geringer Anteil wird ein NCO-Wert von weniger als 0,5% (bezogen auf Polyurethan), vorzugsweise weniger als 0,3% und besonders bevorzugt weniger als 0,2% verstanden.

Als Komponente a) können grundsätzlich alle im wesentlichen von NCO-Gruppen freien Polyurethane mit mindestens einer olefinisch ungesättigten Doppelbindung verwendet werden. Hierzu zählen sowohl die Polyurethane, die in der Regel nur durch Zusatz von Emulgatoren, Dispergatoren und/oder Schutzkolloiden in eine wäßrige Dispersion überführbar sind als auch die sog. selbstdispergierbaren Polyurethane, die wenigstens weitgehend ohne Zusatz von Hilfsmitteln in Wasser im wesentlichen selbstdispergierbar sind.

Vorzugsweise enthalten die als Komponente a) im Sinne der Erfindung einsetzbaren Polyurethane jedoch keine tertiären Aminogruppen, um die o.g. Nachteile bei der Reaktionsführung zu vermeiden.

Die erfindungsgemäß einsetzbaren Polyurethane sind beispielsweise erhältlich durch Umsetzung von
A) Polyisocyanaten mit
B1) Polyolen mit einem Molekulargewicht von 500 oder mehr
B2) Polyolen mit einem Molekulargewicht von weniger als 500 oder Gemischen von B1) und B2) und
C) gegebenenfalls Verbindungen mit mindestens einer gegenüber Isocyanaten reaktionsfähigen Gruppe und mindestens einer olefinisch ungesättigten Doppelbindung und
D) gegebenenfalls Verbindungen mit mindestens einer gegenüber Isocyanaten reaktionsfähigen Gruppe und mindestens einer durch Basen- oder Säurezugabe ionisierbaren Gruppe.

Als Komponente A) zur Herstellung der erfindungsgemäßen Polyurethane kommen die üblicherweise in der Polyurethanchemie eingesetzten Polyisocyanate in Betracht.

Insbesondere zu nennen sind die Diisocyanate X(NCO)₂, wobei X für einen aliphatischen Kohlenwasserstoffrest mit 4 bis 12 Kohlenstoffatomen, einen cycloaliphatischen oder aromatischen Kohlenwasserstoffrest mit 6 bis 15 Kohlenstoffatomen oder einen araliphatischen Kohlenwasserstoffrest mit 7 bis 15 Kohlenstoffatomen steht. Beispiele derartiger Diisocyanate sind Tetramethylendiisocyanat, Hexamethylendiisocyanat, Dodecamethylendiisocyanat, 1,4-Diisocyanatocyclohexan, 1-Isocyanato-3,3,5-trimethyl-5-isocyanatomethylcyclohexan (IPDI), 2,2-Bis-(4-isocyanatocyclohexyl)-propan, Trimethylhexandiisocyanat, 1,4-Diisocyanatobenzol, 2,4-Diisocyanatotoluol, 2,6-Diisocyanatotoluol, 4,4'-Diisocyanatodiphenylmethan, Tetramethylxylylendiisocyanat (TMXDI), 2,4'-Diisocyanatodiphenylmethan, p-Xylylendiisocyanat, die Isomeren des Bis-(4-Isocyanatocyclohexyl)methans, wie das trans/trans-, das cis/cis- und cis/trans-Isomere sowie aus diesen Verbindungen bestehende Gemische.

Als Gemische dieser Isocyanate sind besonders die Gemische der jeweiligen Strukturisomeren von Diisocyanatotoluol und Diisocyanatodiphenylmethan von Bedeutung, insbesondere ist das Gemisch aus etwa 80 mol-% 2,4-Diisocyanatotoluol und etwa 20 mol-% 2,6-Diisocyanatotoluol geeignet. Gegebenenfalls können die aromatischen Diisocyanate mit aliphatischen Diisocyanaten abgemischt sein.

Gegebenenfalls können auch solche Isocyanate mitverwendet werden, die nur eine Isocyanatgruppe tragen. Im allgemeinen beträgt ihr Anteil maximal 10 mol-%, bezogen auf die gesamte Molmenge der Monomeren. Die Monoisocyanate tragen üblicherweise weitere funktionelle Gruppen, wie beispielsweise olefinisch ungesättigte Doppelbindungen.

Um Polyurethane mit einem gewissen Verzweigungs- oder Vernetzungsgrad herzustellen, können z.B. drei- und/oder vierwertige Isocyanate eingesetzt werden. Derartige Isocyanate werden z.B. erhalten, indem man zweiwertige Isocyanate derart miteinander umsetzt, daß ein Teil ihrer Isocyanatgruppen zu Allophanat-, Biuret- oder Isocyanuratgruppen derivatisiert wird.

Handelsübliche Verbindungen sind beispielsweise das Isocyanurat oder das Biuret des Hexamethylendiisocyanats.

Weitere geeignete, höherfunktionelle Polyisocyanate sind z.B. Urethangruppen aufweisende Polyisocyanate, die durch Umsetzung eines Überschusses von beispielsweise 2,4- und/oder 2,6-Diisocyanatotoluol, IPDI oder Tetramethylendiisocyanat einerseits und niedermolekularen Polyhydroxyverbindungen wie Trimethylolpropan andererseits erhältlich sind.

Bevorzugt werden im Sinne der vorliegenden Erfindung als Isocyanatkomponente A) Di- oder Polyisocyanate eingesetzt, die einen hohen Anteil an aromatischen Di- oder Polyisocyanaten aufweisen. Besonders bevorzugt ist die ausschließliche Verwendung von aromatischen Di- oder Polyisocyanaten.

Im Hinblick auf gute Filmbildung und Elastizität kommen als Komponente B1) vornehmlich höhermolekulare Polyole, bevorzugt Diole in Betracht, die ein Molekulargewicht von mehr als 500, beispielsweise etwa 500 bis 5.000, vorzugsweise von etwa 1.000 bis etwa 3.000 g/mol haben.

Bei den Polyolen der Komponente B1) handelt es sich insbesondere um Polyesterpolyole, die z.B. aus ULLMANNS ENZYKLOPÄDIE DER TECHNISCHEN CHEMIE, 4. Auflage, Band 19, S. 62-65, bekannt sind. Bevorzugt werden Polyesterpolyole eingesetzt, die durch Umsetzung von zweiwertigen Alkoholen mit mehrwertigen, bevorzugt zweiwertigen Polycarbonsäuren erhältlich sind. Die Polycarbonsäuren (Komponente B1.1)) können aliphatisch, cycloaliphatisch, araliphatisch, aromatisch oder heterocyclisch sein und gegebenenfalls z.B. durch Halogenatome substituiert und/oder ungesättigt sein. Als Beispiele hierfür seien genannt Korksäure, Azelainsäure, Phthalsäure, Isophthalsäure, Terephthalsäure, Phthalsäureanhydrid, Tetrahydrophthalsäureanhydrid, Hexahydrophthalsäureanhydrid, Tetrachlorphthalsäureanhydrid, Endomethylentetrahydrophthalsäureanhydrid, Glutarsäurcanhydrid, Maleinsäure, Maleinsäureanhydrid, Fumarsäure und/oder dimere Fettsäuren. Die genannten Polycarbonsäuren können entweder einzeln als ausschließliche Säurekomponente oder im Gemisch untereinander zum Aufbau der Komponente B1) eingesetzt werden. Bevorzugt sind die Carbonsäuren der allgemeinen Formel HOOC-(CH₂)_{y}-COOH, wobei y eine Zahl von 1 bis 20, bevorzugt eine Zahl von 2 bis 20 ist, z.B. Bernsteinsäure, Adipinsäure, Dodecandicarbonsäure und Sebacinsäure. Anstelle der freien Polycarbonsäuren können als Komponente B1.1), wenn möglich, auch die entsprechenden Polycarbonsäureanhydride oder die entsprechenden Polycarbonsäureester von niederen Alkoholen - oder deren Gemische - zur Herstellung der Polyesterpolyole verwendet werden.

Als mehrwertige Alkohole zur Reaktion mit der Polycarbonsäurekomponente zum Aufbau der Komponente B1) kommen als Komponente B1.2) z.B. Ethylenglycol, Propandiol-1,2, Propandiol-1,3, Butandiol-1,4, Butendiol-1,4, Butindiol-1,4, Pentandiol-1,5, Hexandiol-1,6, Neopentylglycol, Bis-(hydroxymethyl)cyclohexane, wie 1,4-Bis(hydroxymethyl)cyclohexan, 2-Methyl-propan-1,3-diol, Methylpentandiole, ferner Diethylenglycol, Triethylenglycol, Tetraethylenglycol, Polyethylenglycol, Dipropylenglycol, Polypropylenglycole, Dibutylenglycol und Polybutylenglycol in Betracht. Bevorzugt sind Neopentylglycol und Alkohole der allgemeinen Formel HO-(CH₂)ₓ-OH, wobei x eine Zahl von 1 bis 20, bevorzugt eine Zahl von 2 bis 20 ist. Beispiele hierfür sind Ethylenglycol, Butandiol-1,4, Hexandiol-1,6, Octandiol-1,8 und Dodecandiol-1,12.

Ferner kommen als Komponente B1) auch Polycarbonatdiole, wie sie z.B. durch Umsetzung von Phosgen mit einem Überschuß von den als Aufbaukomponenten für die Polyesterpolyole genannten niedermolekularen Alkohole B1.2) erhalten werden können, in Betracht.

Geeignet sind als Komponente B1) auch Polyesterdiole auf Lacton-Basis, wobei es sich um Homo- oder Mischpolymerisate von Lactonen, bevorzugt um endständige Hydroxylgruppen aufweisende Anlagerungsprodukte von Lactonen an geeignete difunktionelle Startermoleküle handelt. Es kommen bevorzugt solche Lactone in Betracht, die sich von Verbindungen der allgemeine Formel HO-(CH₂)_{z}-COOH ableiten, wobei z eine Zahl von 1 bis 20, vorzugsweise von 2 bis 20 ist. Beispiele sind ε-Caprolacton, β-Propiolacton, γ-Butyrolacton oder Methyl-ε-caprolacton sowie Gemische aus zwei oder mehr davon. Geeignete Starterkomponenten sind z.B. die vorstehend als Aufbaukomponente B1.2) für die Polyesterpolyole genannten niedermolekularen zweiwertigen Alkohole. Die entsprechenden Polymerisate des ε-Caprolactons sind besonders bevorzugt. Auch niedermolekulare Polyesterpolyole oder Polyetherdiole können als Starter zur Herstellung der Lactonpolymerisate eingesetzt werden. Anstelle der Lactonpolymerisate können auch die entsprechenden, chemisch äquivalenten Polykondensate der den Lactonen entsprechenden Hydroxycarbonsäuren eingesetzt werden.

Die Polyesterpolyole können auch unter Zuhilfenahme untergeordneter Mengen an monofunktionellen Monomeren aufgebaut werden.

Daneben kommen als Komponente B1) Polyetherdiole in Betracht. Sie sind insbesondere durch Polymerisation von Ethylenoxid, Propylenoxid, Butylenoxid, Tetrahydrofuran, Styroloxid oder Epichlorhydrin mit sich selbst, z.B. in Gegenwart von BF₃, oder durch Anlagerung dieser Verbindungen gegebenenfalls im Gemisch oder nacheinander an Startkomponenten mit reaktionsfähigen Wasserstoffatomen wie Wasser oder Alkohole, z.B. Ethylenglycol, Propandiol-1,2, Propandiol-1,3, 2,2-Bis-(4-hydroxydiphenyl)-propan erhältlich. Besonders bevorzugt ist Polytetrahydrofuran mit einem Molekulargewicht von etwa 500 bis etwa 4.000, bevorzugt von etwa 500 bis etwa 3.000.

Bei Verwendung geeigneter Polyether mit Polyethyleneinheiten mit einem Molekulargewicht von wenigstens etwa 150, bevorzugt wenigstens etwa 200, zur Herstellung der Polyurethane lassen sich in Wasser wenigstens weitgehend selbstdispergierbare Polyurethane herstellen, die ohne Verwendung weiterer hydrophiler Struktureinheiten im Polyurethan auskommen.

Sowohl zur Herstellung der Polyesterpolyole als auch zur Herstellung der Polyetherpolyole können Alkohole mit einer Funktionalität von mehr als zwei in untergeordneten Mengen als Komponente B1.3) eingesetzt werden. Insbesondere sind dies Verbindungen wie beispielsweise Trimethylolpropan, Pentaerythrit, Glycerin, Zucker, wie beispielsweise Glucose oder oligomerisierte Polyole, wie beispielsweise di- oder trimere Ether von Trimethylolpropan, Glycerin oder Pentaerythrit. Gegebenenfalls können die Hydroxylgruppen der Polyole durch Umsetzung mit Alkylenoxiden verethert sein. Die vorstehenden Verbindungen sind ebenfalls als Starterkomponente zum Aufbau der Polyetherpolyole geeignet.

Vorzugsweise werden die Polyolverbindungen der Komponente B1.3) mit einer Funktionalität > 2 nur in untergeordneten Mengen zum Aufbau der Polyesterpolyole bzw. Polyetherpolyole herangezogen.

Ebenfalls als Komponente B1) geeignet sind Polyhydroxyolefine, bevorzugt solche mit zwei endständigen Hydroxylgruppen, z.B. α,ω-Dihydroxypolybutadien, α,ω-Dihydroxypolymethacrylester oder α,ω-Dihydroxypolyacrylester.

Die als Komponente B1) einsetzbar aufgezählten Polyole können auch als Gemische in beliebigen Verhältnissen eingesetzt werden.

Als Polyole B2) können neben den Polyolen B1) noch niedermolekulare Di- oder Polyole, vorzugsweise Diole, mit einem Molekulargewicht von weniger als 500, vorzugsweise 62 bis 499 und besonders bevorzugt 62 bis 200 g/mol eingesetzt werden. Hierdurch können die Härte und das Elastizitätsmodul der Polyurethane erhöht werden.

Als Komponente B2) werden vor allem die als Komponente B1.2) bezeichneten kurzkettigen Alkandiole eingesetzt, wobei Neopentylglycol und die unverzweigten Diole mit 2 bis 12 C-Atomen, wie beispielsweise Ethylenglycol, Propandiol-1,3, Butandiol-1,4, Pentandiol-1,5 oder Hexandiol-1,6 bevorzugt werden. Gegebenenfalls kann die Komponente B2) in untergeordneten Mengen auch höherfunktionelle Alkohole, wie sie beispielsweise als Komponente B1.3) beschrieben sind, beinhalten.

Die zum Aufbau der erfindungsgemäßen Polyurethane beschriebenen Komponenten B1) und B2) können auch als Gemische von B1) und B2) im Sinne der Erfindung eingesetzt werden. Hierbei beträgt der Anteil der Polyole B1), bezogen auf die Gesamtmenge der Polyole B1) plus B2), etwa 9 bis 100 mol-% und der Anteil der Polyole B2), bezogen auf die Gesamtmenge der Polyole B1) plus B2), etwa 0 bis 91 mol-%. Bevorzugt beträgt das Verhältnis der Polyole B2) zu den Polyolen B1) damit etwa 10:1 bis 0:1, besonders bevorzugt etwa 8:1 bis 0:1.

Um gegebenenfalls die Wasserdispergierbarkeit der Polyurethane zu erreichen, werden in die Polyurethane in der Regel hydrophilierende, nichtionische oder anionische bzw. in anionische Gruppen umwandelbare Struktureinheiten eingebaut.

Unter 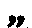 *in anionische Gruppen umwandelbare Struktureinheiten* 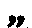 werden im Sinne der vorliegenden Erfindung solche Struktureinheiten verstanden, die durch eine einfache chemische Reaktion, wie beispielsweise Basenzugabe, in eine ionische Form umgewandelt werden können. Beispiele hierfür sind Säuregruppen.

Der Begriff *"in Wasser im wesentlichen selbst dispergierbares Polyurethan"* umfaßt im erfindungsgemäßen Sinne Polyurethane, die durch Zusatz lediglich geringer Mengen oder sogar ganz ohne Zusatz von Dispergierhilfen in Wasser dispergierbar sind. Werden im Rahmen der Erfindung solche Polyurethane eingesetzt, so erfordern sie höchstens einen Zusatz von Dispergierhilfen in einer Größenordnung von etwa 5 Gew.-%, bevorzugt weniger als 3 Gew.-% und insbesondere bevorzugt weniger als 1 Gew.-%, bezogen auf die Trockenmasse der Dispersion und insbesondere bezogen auf die Masse der Bindemittel in der Dispersion.

Neben den Komponenten A) sowie B1) und/oder B2) können bei der Herstellung der erfindungsgemäßen Polyurethane als Komponente C) Verbindungen mit mindestens einer gegenüber Isocyanaten reaktionsfähigen Gruppe und mindestens einer durch Säurezugabe ionisierbaren Gruppe oder einer schon durch eine solche Reaktion ionisierte Gruppe eingebaut werden. Im folgenden Text wird der Begriff 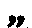 *anionische Gruppen* 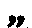 sowohl für die durch Basenzugabe ionisierten Gruppen als auch für die freien Säuren synonym gebraucht, insofern keine anderslautenden Angaben gemacht sind. Die anionischen Gruppen reagieren mit Isocyanaten wesentlich langsamer als die funktionellen Gruppen der Komponente D), die zum Aufbau der Polymerhauptkette dienen.

Der Anteil der Komponenten mit anionischen Gruppen an der Gesamtmenge der Komponenten A), B1), B2) und C), insofern sie zur Herstellung des Polyurethans benutzt werden, wird im allgemeinen so bemessen, daß die Molmenge der anionischen Gruppen, bezogen auf die Gewichtsmenge aller eingesetzten Komponenten, 0 bis 1.000, bevorzugt 0 bis 600 und besonders bevorzugt 0 bis 500 mmol/kg beträgt.

Als Komponente C) werden vor allem anionische Gruppen tragende Verbindungen, wie Sulfonat-, Carboxylat- und Phosphonatgruppen tragende Verbindungen, in das Polyurethan eingebaut. Die anionischen Gruppen werden vorzugsweise in Form der freien Säure oder aber in Form ihrer Alkalimetall- oder Ammoniumsalze eingebaut, wobei als Gegenionen kationische Gruppen, wie Ammoniumgruppen, insbesondere protonierte tertiäre Aminogruppen oder quartäre Ammoniumgruppen, besonders geeignet sind.

Potentielle anionische hydrophile Gruppen sind vor allem solche, die sich durch einfache Neutralisations- oder Hydrolysereaktionen in die oben genannten anionischen hydrophilen Gruppen überführen lassen, also z.B. Carbonsäuregruppen oder Anhydridgruppen.

Als Monomere mit anionischen Gruppen kommen üblicherweise aliphatische, cycloaliphatische, araliphatische oder aromatische Carbonsäuren und Sulfonsäuren in Betracht, die mindestens eine alkoholische Hydroxylgruppe tragen. Bevorzugt sind die Hydroxyalkylcarbonsäuren, vor allem diejenigen mit 3 bis 10 Kohlenstoffatomen, wie sie auch in der US-A 3,412,054 beschrieben sind. Besonders bevorzugt ist die Dimethylolpropionsäure (DMPA).

Weiterhin eignen sich als Komponente C) entsprechende Dihydroxysulfonsäuren und Dihydroxyphosphonsäuren.

Ansonsten geeignet sind Hydroxyverbindungen mit einem Molekulargewicht von über 500 bis 10.000 g/mol mit mindestens zwei Carboxylatgruppen, die beispielsweise aus der DE-A 3 911 827 bekannt sind. Sie sind durch Umsetzung von Polyhydroxyverbindungen, bevorzugt Dihydroxyverbindungen mit Tetracarbonsäuredianhydriden, wie Pyromellithsäuredianhydrid oder Cyclopentantetracarbonsäuredianhydrid, im Molverhältnis 2 : 1 bis 1,05 : 1 in einer Polyadditionsreaktion erhältlich. Als Polyhydroxyverbindungen sind insbesondere die unter B1.2) und B1.3) aufgeführten niedermolekularen Di- und Polyole geeignet.

Werden zur Herstellung der erfindungsgemäßen Aminogruppen tragenden Polyurethane anionische Gruppen tragende Polyurethane eingesetzt, so weisen diese vorzugsweise Carboxylat- oder Sulfonatgruppen oder beides auf.

Als Komponente D) werden zur Herstellung des erfindungsgemäßen Polyurethans Verbindungen mit mindestens einer gegenüber Isocyanaten reaktionsfähigen Gruppe und mit mindestens einer olefinisch ungesättigten Doppelbindung eingesetzt. Vorzugsweise ist die olefinisch ungesättigte Doppelbindung leicht einer radikalischen Polymerisation zugänglich und besonders bevorzugt handelt es sich um eine durch aromatische Gruppen oder insbesondere durch Carbonylgruppen aktivierte Doppelbindung wie sie beispielsweise in Styrol oder in Acrylsäure, Methacrylsäure oder deren Estern vorkommt.

Im folgenden wird bei Bezugnahme auf Acrylsäure und Methacrylsäure oder deren Derivate die Schreibweise (Meth)acrylsäure, wie beispielsweise Poly(meth)acrylsäure benutzt.

Werden als Komponente D) Verbindungen mit lediglich einer Isocyanaten gegenüber reaktionsfähigen Gruppe eingesetzt, so werden die olefinisch ungesättigten Doppelbindungen am Ende der Polyurethankette eingebaut. Bei der Verwendung einer Verbindung, die zwei oder mehr gegenüber Isocyanaten reaktionsfähigen Gruppen aufweist und mindestens eine olefinisch ungesättigte Doppelbindung enthält als Komponente D), erfolgt der Einbau bei entsprechender Reaktionsführung in der Regel innerhalb der Polyurethankette, obwohl auch hier ein Einbau am Kettenende möglich ist. Unter 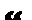 *Einbau in der Polyurethankette* 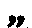 wird im erfindungsgemäßen Sinne sowohl der Einbau der Doppelbindung als Teil des Polymerrückgrats als auch eine Einführung der Doppelbindung in Form einer Seitenkette verstanden. Als geeignete Monomere, die Hydroxylgruppen und mindestens eine olefinisch ungesättigte Doppelbindung enthalten, kommen beispielsweise Hydroxyalkyl(meth)acrylate, wie 2-Hydroxyethyl(meth)acrylat, 2-Hydroxypropyl(meth)acrylat und 4-Hydroxybutyl(meth)acrylat, in Frage. Ebenfalls geeignet sind Polypropylenglycolmono(meth)acrylate und Polyethylenglycolmono(meth)acrylate. Zur Einführung von mehreren olefinisch ungesättigten Doppelbindungen sind die Polymethacrylate von mehrwertigen Alkoholen, wie Glycerindi(meth)acrylat, Trimethylolpropandi(meth)acrylat, Pentaerythritdi- oder Pentaerythrittri(meth)acrylat oder Gemische aus zwei oder mehr davon, geeignet.

Zum Einbau olefinisch ungesättigter Doppelbindungen als Seitenkette am Polymerrückgrat sind beispielsweise Verbindungen wie Glycerinmono(meth)acrylat, Trimethylolpropanmono(meth)acrylat, Pentaerythrit-mono- oder Pentaerythrit-di(meth)acrylat geeignet. Ebenfalls zu diesem Zweck einsetzbar sind die Ringöffnungsprodukte von (Meth)acrylsäure mit Bis-Epoxiden wie beispielsweise den Glycidylethern von Bisphenol-A, Butandiol-1,4 oder Hexandiol-1,6 oder Gemischen aus zwei oder mehr davon.

Gegebenenfalls können als Komponente D) auch oligomere oder polymere Verbindungen, die mindestens eine gegenüber Isocyanaten reaktionsfähige Gruppe und mindestens eine olefinisch ungesättigte Doppelbindung tragen, eingesetzt werden. Hierzu zählen beispielsweise Polyester, die unter Zuhilfenahme olefinisch ungesättigter Di- oder Polyole oder vorzugsweise unter Zuhilfenahme olefinisch ungesättigter Dicarbonsäuren oder Polycarbonsäuren hergestellt wurden. Bevorzugt ist die Verwendung solcher Polyester die unter Verwendung der unter B1.1) und B1.2) beschriebenen Komponenten unter zumindest anteiligem Ersatz der Komponente B1.1) durch ungesättigte Dicarbonsäuren oder Dicarbonsäureanhydride, wie beispielsweise Maleinsäure, Maleinsäureanhydrid oder Fumarsäure herstellbar sind. In diesem Fall wird die Doppelbindung als Bestandteil des Polymerrückgrats innerhalb desselben eingebaut.

Eine weitere Möglichkeit zur Einführung olefinisch ungesättigter Doppelbindungen in das erfindungsgemäße Polyurethan kann beispielsweise nach einer Methode durchgeführt werden, wie sie in der WO 96/08524 beschrieben ist. Hier wird beispielsweise ein Carbodiimid der allgemeinen Formel

OCN-(R-N=C=N)ₘ-R-NCO,

wobei R für eine zweiwertige organische Gruppe steht, die gegenüber allen im Reaktionsgemisch vorliegenden funktionellen Gruppen unter den Umsetzungsbedingungen inert ist, mit olefinisch ungesättigte Doppelbindungen aufweisenden Monocarbonsäuren umgesetzt. R steht hierbei für einen zweiwertigen organischen Rest, vorzugsweise einen Alkylen-, Aralkylen- oder Arylenrest oder einen heterocyclischen Rest. Vorzugsweise steht R für einen Alkylenrest mit 2 bis 12 Kohlenstoffatomen. Als mindestens eine ungesättigte Doppelbindung aufweisende Monocarbonsäure können beispielsweise Acrylsäure, Methacrylsäure oder Itaconsäure dienen. Weiterhin können als im Sinne der durchzuführenden Reaktion ungesättigte Monocarbonsäuren auch die Halbester von ungesättigten Dicarbonsäuren eingesetzt werden. Hierzu zählen beispielsweise die Halbester von Maleinsäure oder Fumarsäure mit Monoalkoholen, wie beispielsweise Methanol, Ethanol, Propanol oder Butanol. Ebenfalls einsetzbar sind die Halbester mit höheren Monoalkoholen, wie beispielsweise die Veresterungsprodukte zwischen Maleinsäure oder Fumarsäure und Decanol, Laurylalkohol, Myristylalkohol oder noch höhermolekularen Monoalkoholen.

Das bei der o.g. Umsetzung zwischen Säure und Carbodiimid entstehende Diisocyanat kann als Diisocyanatkomponente A) bei der Synthese der erfindungsgemäßen Polyurethane eingesetzt werden.

Zur Neutralisation werden die gegebenenfalls im erfindungsgemäßen Polyurethan enthaltenen Säuregruppen vor oder bevorzugt nach dem Einbau in die Polyurethahkette mit einem basischen Neutralisationsmittel neutralisiert. Als basische Neutralisationsmittel sind in der Regel beispielsweise die Alkalimetalle wie Li, Na oder K sowie die Erdalkalimetalle wie Ca, Mg, Ba oder Sr geeignet, obwohl sie im Rahmen der vorliegenden Erfindung nicht bevorzugt sind. Besser geeignet und im Rahmen der vorliegenden Erfindung bevorzugt sind alle Salze der o.g. Metalle, die in der Lage sind unter Neutralisation der Säuregruppen zu reagieren, insbesondere die Carbonate, die Hydrogencarbonate oder besonders bevorzugt die Hydroxide wie beispielsweise LiOH, NaOH, KOH oder Ca(OH)₂.

Ebenso zur Neutralisation geeignet und im Rahmen der vorliegenden Erfindung besonders bevorzugt sind organische, stickstoffhaltige Basen wie beispielsweise Ammoniak und Amine, wie Trimethylamin, Triethylamin, Tributylamin, Dimethylanilin, Dimethylethanolamin, Methyldiethanolamin oder Triethanolamin sowie deren Gemische. Die Neutralisation mit den stickstoffhaltigen, organischen Basen kann in organischer oder in wäßriger Phase erfolgen. Mit stickstoffhaltigen Basen neutralisierte Verbindungen der Komponente D) eignen sich daher in der Regel auch in neutralisierter Form zum Einbau in das Polyurethan in organischer Lösung.

Wenn im erfindungsgemäßen Polyurethan ionisierbare Gruppen enthalten sind, die sich durch Basenzugabe zu anionischen Gruppen umwandeln lassen, so kann das Neutralisationsmittel in einer solchen Menge zugesetzt werden, daß ein ausreichender Anteil der ionisierbaren Gruppen, in der Regel etwa 0,1 bis 100%, neutralisiert wird. In der Regel findet eine Neutralisation zu mindestens 10%, bevorzugt zu mindestens 25% und insbesondere bevorzugt zu mindestens 50% statt. Es ist jedoch ebenfalls möglich, die im erfindungsgemäßen Polyurethan enthaltenen ionisierbaren Gruppen zu wenigstens 75% oder beispielsweise auch weitgehend vollständig, d.h. zu etwa 100%, zu neutralisieren.

Das Polyurethanharz kann durch gleichzeitige Umsetzung aller Ausgangsverbindungen hergestellt werden. In vielen Fällen ist es jedoch zweckmäßig, das Polyurethanharz stufenweise herzustellen. So ist es z.B. möglich, aus den Komponenten A) und B) ein Isocyanatgruppen-haltiges Prepolymer herzustellen, das dann gegebenenfalls mit den Komponenten C) oder D) weiter umgesetzt wird.

Die Umsetzung der Komponenten A) bis D) kann auch in Gegenwart von Katalysatoren wie z.B. Dibutylzinndilaurat oder Dibutylzinndimaleat durchgeführt werden. Die einzusetzenden Mengen der Komponenten A), B), C) und D) ergeben sich aus dem angestrebten Zahlenmittel des Molekulargewichts und dem angestrebten Anteil an ionischen Gruppen.

Üblicherweise wird die Herstellung der erfindungsgemäßen Polyurethanharze in Gegenwart von organischen Lösemitteln durchgeführt, wenngleich auch eine Herstellung in Substanz möglich, aber nicht bevorzugt ist. Als Lösemittel sind grundsätzlich alle Lösemittel geeignet, die sowohl die zur Polyurethanharzherstellung eingesetzten Monomerkomponenten als auch das fertige Polyurethanharz in ausreichender Menge lösen, ohne daß es zu Koagulations- oder Ausfällungserscheinungen kommt. Als Lösemittel dienen in der Regel flüssige, aliphatische Ketone wie beispielsweise Aceton, Methylethylketon oder Methylisobutylketon, Ester aliphatischer Monocarbonsäuren wie beispielsweise Essigsäuremethylester, Essigsäureethylester, Essigsäurepropylester oder Essigsäureisobutylester, aromatische Kohlenwasserstoffe, wie beispielsweise Toluol oder Xylol, halogenierte aromatische Kohlenwasserstoffe, wie beispielsweise Chlorbenzol und Dichlorbenzol, sowie stickstoffhaltige polare aprotische Lösemittel, wie Dimethylformamid (DMF), Dimethylacetamid (DMAc) oder N-Methylpyrrolidon (NMP). Die angegebenen Lösemittel können alleine oder im Gemisch verwendet werden. Bevorzugt ist in der Regel der Einsatz von Aceton oder Methyl-Ethylketon oder von Gemischen aus Aceton und Methyl-Ethylketon.

Neben den als Komponente a) im Reaktionsgemisch vorliegenden, im wesentlichen von NCO-Gruppen freien Polyurethanmolekülen mit mindestens einer olefinisch ungesättigten Doppelbindung, liegen im Reaktionsgemisch als Komponente b) Ammoniak oder mindestens ein primäres Amin oder mindestens ein sekundäres Amin oder ein Gemisch aus zwei oder mehreren davon vor.

Das mindestens eine primäre Amin kann sowohl ein monoprimäres Amin, d.h. ein Amin mit lediglich einer primären Aminogruppe sein, es können jedoch auch di- oder polyprimäre Amine, d.h. Amine mit zwei oder mehr primären Aminogruppen zum Einsatz kommen.

Das mindestens eine sekundäre Amin kann sowohl ein monosekundäres Amin, d.h. ein Amin mit lediglich einer sekundären Aminogruppe sein, es können jedoch auch di- oder polysekundäre Amine, d.h. Amine mit zwei oder mehr sekundären Aminogruppen zum Einsatz kommen.

Ebenfalls möglich ist der Einsatz von gemischten Aminen, die sowohl primäre als auch sekundäre Aminogruppen aufweisen. Es ist dabei auch möglich, daß ein Amin beispielsweise mehrere primäre und nur eine sekundäre Aminogruppe aufweist oder mehr sekundäre als primäre Aminogruppen besitzt.

Die Amine gehen mit den im Polyurethan vorliegenden Doppelbindungen eine Additionsreaktion ein. Die Doppelbindungen fungieren dabei als vinyloge Elektronenakzeptoren im Sinne einer Michael-Addition.

Grundsätzlich erfolgt die Reaktion zwischen olefinisch ungesättigten Doppelbindungen und Ammoniak und Aminen dergestalt, daß pro Doppelbindung eine Addition mit einem am Aminstickstoff vorhandenen reaktiven Zentrum stattfindet. Unter dem Begriff *"reaktives Zentrum"* oder *"reaktive Zentren"* wird demnach die Zahl der aciden Wasserstoffatome am Aminstickstoff verstanden. Acide Wasserstoffatome sind solche Wasserstoffatome, die durch den dem Fachmann bekannten Zerewittinoff-Test bestimmbar sind. Ammoniak verfügt demnach über drei solcher reaktiver Zentren, ein primäres Amin über zwei reaktive Zentren und ein sekundäres Amin über ein reaktives Zentrum.

Über Art und Menge des bei der Umsetzung vorliegenden Amins lassen sich die Eigenschaften des Polyurethans nach der Umsetzung mit dem Amin beeinflussen. Da beispielsweise ein Ammoniakmolekül in der Lage ist, mit drei Doppelbindungen zu reagieren, ist bei einer Reaktion von Ammoniak mit einem Gemisch aus wenigstens zwei olefinisch ungesättigte Doppelbindungen tragenden Polyurethan damit zu rechnen, daß eine starke Verzweigung und gegebenenfalls Gelierung des Ansatzes stattfindet.

Wird als Amin ein monoprimäres Amin eingesetzt, so kann dies mit Polyurethanmolekülen, die pro Molekül über lediglich zwei olefinisch ungesättigte Doppelbindungen verfügen, zu einer Kettenverlängerung führen. Weist das Polyurethanmolekül mehr als zwei olefinisch ungesättigten Doppelbindungen auf, so wird in der Regel eine zumindest teilweise Vernetzung der Polyurethanmoleküle erfolgen.

Die Umsetzung eines monosekundären Amins mit einem eine oder mehrere ungesättigte Doppelbindungen aufweisenden Polyurethan kann üblicherweise nicht zu einer Vernetzung führen, da jedes sekundäre Amin nur mit einer Doppelbindung reagieren kann. Diese Methode ist daher vorzugsweise dann zu benutzen, wem sichergestellt werden soll, daß keine wesentlichen Molekulargewichtsveränderungen auftreten sollen und eine Vernetzung der Polyurethanmoleküle verhindert wird.

Entsprechende Zusammenhänge beim Einsatz von Aminen mit mehr als einer primären oder mehr als einer sekundären Aminogruppe oder beim Einsatz von gemischten Aminen, die sowohl primäre als auch sekundäre Aminogruppen tragen, sind dem Fachmann bekannt.

Beispiele für monoprimäre Amine sind Ethylamin, Propylamin, n-Butylamin, tert.-Butylamin, Pentylamin, Hexylamin sowie weitere primäre Amine von höheren, linearen oder verzweigten, gesättigten oder ungesättigten Alkanen. Ebenfalls einsetzbar sind die monoprimären Amine, deren Kohlenwasserstoffgerüst aromatische Einheiten aufweist. Bei diesen Aminen ist jedoch zu beachten, daß sie zum Teil für Menschen erheblich toxisch sind. Der Einsatz solcher aromatischen Amine ist im Sinne der Erfindung zwar möglich, aber nicht bevorzugt. Vertreter dieser Substanzklasse sind beispielsweise Anilin, Aminotoluole, Aminoxylole sowie weitere aminosubstituierte aromatische Verbindungen. Gegebenenfalls kann, wie beispielsweise im Benzylamin, zwischen aromatischem Grundkörper und Aminofunktion beispielsweise eine Alkylenkette liegen.

Zu den monosekundären Aminen zählen beispielsweise Dimethylamin, Methylethylamin, Diethylamin, Methylpropylamin, Methylbutylamin, Methylpentylamin, Methylhexylamin, Ethylpropylamin, Ethylbutylamin, Ethylpentylamin sowie die methyl-, ethyl- oder gegebenenfalls propylsubstituierten Amine der höheren, linearen oder verzweigten Alkane. Ebenfalls einsetzbar sind im Sinne des oben Gesagten auch die aromatischen Amine, wobei hier in der Regel auf methyl- oder ethylsubstituierte Verbindungen zurückgegriffen wird.

Ebenso einsetzbar sind unter Berücksichtigung der o.g. Einflüsse auf das resultierende Polymere, Di-, Tri- oder höhere Amine. Hierzu zählen beispielsweise Ethylendiamin, Propylendiamin, Butylendiamin, Diethylentriamin, Triethylentetramin oder deren Methyl- und Ethyl-substituierte Analoga.

Als Komponente B) werden vorzugsweise primäre oder sekundäre Amine oder deren Gemische eingesetzt.

Im Sinne der Erfindung besonders bevorzugte Amine sind beispielsweise Bis-(3-Aminopropyl)-methylamin, Bis-1,3-(N,N'-Dimethylaminopropylamino)-2-methylpropan, N,N'-Dimethyl-1,3-propandiamin oder 3-(N,N-Dimethylamino)-propylamin.

Neben den Komponenten a) und b) kann im Reaktionsgemisch als Komponente c) mindestens eine von Urethangruppen freie Verbindung mit mindestens einer olefinischen Doppelbindung vorliegen. Als Komponente c) einzusetzende Verbindungen sind in der Regel flüssig.

Als Komponente c) einsetzbare Verbindungen erfüllen in der Regel die Aufgabe eines sog. Reaktivverdünners. Unter *"Reaktivverdünner"* wird im Sinne der vorliegenden Erfindung jede Substanz verstanden, die vor der Vernetzungsreaktion dazu dient, die Viskosität der Beschichtungsmittelzusammensetzung zu verringern. Der Reaktivverdünner nimmt jedoch an der Vernetzungsreaktion teil, so daß eine spätere Entfernung des Reaktivverdünners im Sinne einer Trocknung nicht notwendig ist.

Als Komponente c) können beispielsweise aliphatische, cycloaliphatische oder aromatische Ester der Acrylsäure oder Methacrylsäure, die weder Hydroxyl- noch Carboxylgruppen enthalten oder ein Gemisch aus zwei oder mehr solcher Ester eingesetzt werden.

Beispielsweise sind dies: Cyclohexylacrylat, Cyclohexylmethacrylat, Alkylacrylate und Alkylmethacrylate mit bis zu 20 Kohlenstoffatomen im Alkylrest wie z.B. Methyl-, Ethyl-, Propyl-, Butyl-, Hexyl-, Ethylhexyl-, Stearyl- und Laurylacrylat oder -methacrylat oder Gemische aus zwei oder mehr dieser Verbindungen.

Neben den genannten Estern der Acrylsäure oder Methacrylsäure, die nur eine Doppelbindung aufweisen, können auch Acrylester oder Methacrylester mit mehr als einer Doppelbindung im Sinne der Erfindung eingesetzt werden. Solche Verbindungen entstehen beispielsweise bei der Veresterung von Acrylsäure oder Methacrylsäure oder Gemischen dieser beiden Säuren mit mindestens difunktionellen Alkoholen, wie beispielsweise Ethylenglykol, Propylenglykol, Butylenglykol, Pentandiol-1,5 oder Hexandiol-1,6. Ebenso geeignet sind beispielsweise die Veresterungsprodukte mit tri-, tetra- oder noch höher funktionellen Alkoholen wie beispielsweise Glycerin, Trimethylolpropan, Pentaerythrit, Oligo- oder Polyglycerin, Glucose, Sorbit, Mannit oder höheren Kohlenhydraten.

Ebenso können als Komponente c) die Veresterungsprodukte eingesetzt werden, die sich aus der Umsetzung von Acryl- oder Methacrylsäure mit den o.g. Alkoholen ergeben, die vorher mit Ethylenoxid oder Propylenoxid umgesetzt wurden.

Weiterhin können als Komponente c) höhermolekulare Verbindungen, die frei von Urethangruppen sind und mindestens eine olefinisch ungesättigte Doppelbindung aufweisen, eingesetzt werden. Hierzu zählen beispielsweise die ungesättigten Polyester, die unter Verwendung einer oder mehrerer olefinisch ungesättigter Polycarbonsäuren hergestellt werden. Weiterhin zählen hierzu olefinisch ungesättigte Polymerisate, wie sie beispielsweise durch polymeranaloge Funktionalisierung von Polymerisaten mit olefinisch ungesättigte Doppelbindungen enthaltenden Verbindungen herstellbar sind.

Die erfindungsgemäßen Polyurethane werden erhalten, wenn das molare Verhältnis von olefinisch ungesättigten Doppelbindungen zu aciden, von Ammoniak oder Aminen stammenden Wasserstoffatomen im Reaktionsgemisch größer als 10 : 8 ist, vorzugsweise von 10 : 7 bis 10 : 2 und besonders bevorzugt von 10 : 7 bis 10 : 3 beträgt.

Hierbei wird der Gehalt an olefinisch ungesättigten Doppelbindungen auf alle im Reaktionsgemisch vorliegenden Verbindungen bezogen, die eine solche olefinisch ungesättigte Doppelbindung tragen.

Die erfindungsgemäßen Polyurethane stellen die Grundlage für eine Vielzahl von Anwendungen dar, insbesondere im Bereich der Beschichtung von Gegenständen. So ist es möglich, aber im Sinne der Erfindung nicht bevorzugt, die erfindungsgemäßen Polyurethane zum Herstellen einer dekorativen Beschichtung zu nutzen. Ebenso ist es möglich, aber im Rahmen der Erfindung nicht bevorzugt, die Polyurethane beispielsweise als strahlungshärtbare Druckfarben einzusetzen.

Die erfindungsgemäßen Polyurethane können gegebenenfalls unter Zugabe weiterer, beschichtungsmittelüblicher Zusatzstoffe zu Beschichtungsmittelzusammensetzungen verarbeitet werden. Die Beschichtungsmittelzusammensetzung kann dabei auf Basis von organischen Lösemitteln aufgebaut sein, bevorzugt ist es jedoch, die erfindungsgemäßen Polyurethane in Beschichtungsmittelzusammensetzungen auf wäßriger Basis oder gegebenenfalls völlig Lösemittelfrei, beispielsweise als Schmelze, einzusetzen. In diesem Zusammenhang werden unter *"Lösemittel"* sowohl organische Lösemittel als auch Wasser oder wäßrige Lösemittel, d.h. Gemische aus einem oder mehreren organischen Lösemitteln mit Wasser, verstanden.

Unter *"Beschichtungsmittelzusammensetzung"* wird im erfindungsgemäßen Sinne ein Gemisch, enthaltend mindestens ein erfindungsgemäßes Polyurethan oder ein Gemisch aus zwei oder mehreren erfindungsgemäßen Polyurethanen sowie (für den Fall, daß das erfindungsgemäße Polyurethan oder ein Gemisch aus zwei oder mehreren erfindungsgemäßen Polyurethanen nicht aus der Schmelze aufgetragen wird) mindestens ein Lösemittel oder ein Gemisch aus zwei oder mehreren Lösemitteln verstanden. Als Lösemittel können die im Rahmen dieses Textes beschriebenen organischen oder wäßrigen Lösemittel oder Wasser dienen. Einen Sonderfall stellen in diesem Zusammenhang diejenigen erfindungsgemäßen Polyurethane oder Gemische aus zwei oder mehreren solcher erfindungsgemäßen Polyurethane dar, die beispielsweise durch Extrusion direkt auf den zu beschichtenden Gegenstand aufgetragen werden. Ein solches Polyurethan oder ein solches Gemisch aus zwei oder mehr solcher erfindungsgemäßen Polyurethane wird im Rahmen der vorliegenden Erfindung von dem Begriff "Beschichtungsmittelzusammensetzung" mit umfaßt. Vorteilhafterweise enthalten diese erfindungsgemäßen Polyurethane oder Gemische aus zwei oder mehr erfindungsgemäßen Polyurethanen jedoch noch mindestens eine weitere Komponente, wie beispielsweise einen Photoinitiator. Auch solche Gemische fallen unter den Begriff "Beschichtungsmittelzusammensetzung".

Gegenstand der Erfindung ist daher auch eine Beschichtungsmittelzusammensetzung, enthaltend eines der erfindungsgemäßen Polyurethane oder ein Gemisch aus zwei oder mehr erfindungsgemäßen Polyurethanen. Bevorzugt enthält die Beschichtungsmittelzusammensetzung mindestens einen Photoinitiator.

Der mindestens eine Photoinitiator ist dazu in der Lage, bei Bestrahlung mit einer Strahlungsquelle, vorzugsweise bei Bestrahlung mit einer Lichtquelle, eine radikalische Polymerisation der in der Beschichtungsmittelzusammensetzung enthaltenen Doppelbindungen zu initiieren. Bei der Strahlung handelt es sich vorzugsweise um energiereiche Strahlung und besonders bevorzugt um kurzwelliges Licht, beispielsweise um UV-Licht (aktinisches Licht).

Der mindestens eine Photoinitiator kann, insofern er gegenüber den im Reaktionsgemisch vorliegenden, reaktiven Gruppen inert ist, bereits bei der Herstellung des Polyurethans zugegeben werden.

Eine weitere Möglichkeit besteht darin, den Photoinitiator im Anschluß an die Herstellung des Polyurethans zuzugeben. Letzteres geschieht in der Regel während der Zubereitung einer das erfindungsgemäße Polyurethan enthaltenden Beschichtungsmittelzusammensetzung. Basiert die Beschichtungsmittelzusammensetzung auf organischen Lösemitteln, so kann der in der Regel in organischen Lösemitteln lösliche mindestens eine Photoinitiator durch einfaches Einrühren in die Beschichtungsmittelzusammensetzung eingebracht werden. Basiert die Beschichtungsmittelzusammensetzung auf einer wäßrigen Dispersion, so wird der Photoinitiator in der Regel entweder während der Dispergierphase oder im Anschluß an die Dispergierphase in die Dispersion eingebracht.

Als Photoinitiatoren können alle Photoinitiatoren verwendet werden, welche die oben beschriebenen Eigenschaften bezüglich der Initiierung von radikalischen Polymerisationen erfüllen. Insbesondere sind dies Benzilketale und Acetophenone, α-Sulfonylketone, niedermolekulare Phenylglyoxylsäureester- oder -amide, Acylphosphinoxide, Benzophenone oder Thioxanthone.

Ein bevorzugtes Einsatzgebiet für die erfindungsgemäßen Beschichtungsmittelzusammensetzungen liegt auf dem Gebiet der photopolymerisierbaren Aufzeichnungsmaterialien, die mindestens eine auf einem Schichtträger aufgebrachte photopolymerisierbare Schicht umfassen.

Für Materialien, die zur Herstellung solcher photopolymerisierbaren Schichten geeignet sind, ist es wichtig, daß sie leicht herstellbar, bereits vor der Belichtung leicht handhabbar und verarbeitbar sind sowie eine möglichst geringe Neigung zum Kaltfluß und insbesondere zum Verspröden besitzen und eine möglichst geringe Haut- und Kontaktgiftigkeit aufweisen. Das photopolymerisierbare Aufzeichnungsmaterial soll sich zur Herstellung von photopolymerisierbaren Druckplatten, beispielsweise von Reliefdruckplatten, insbesondere von weichelastomeren Reliefdruckplatten eignen. Dementsprechend soll es über gute Belichtungseigenschaften und hohes Auflösungsvermögen sowie gute Druckeigenschaften nach der Belichtung und Entwicklung besitzen. Die Entwicklung des belichteten Aufzeichnungsmaterials soll in umweltfreundlichen Lösemitteln, insbesondere in Wasser oder wäßrigen Medien durchgeführt werden können.

Eine photopolymerisierbare Druckplatte besteht in der Regel aus einer Deckfolie, einer oder mehreren Deckschichten, der photopolymerisierbaren Schicht, gegebenenfalls einem oder mehreren Haftlacken sowie einer Trägersubstanz. Üblicherweise wird bei der Herstellung solcher photopolymerisierbaren Druckplatten zunächst auf die spätere Deckfolie mittels einer Gießlösung eine oder mehrere Deckschichten aufgetragen. Auf das so vorbereitete Laminat aus Deckfolie und Deckschicht wird ebenfalls in der Regel mittels eines Gießers die erfindungsgemäße Beschichtungsmittelzusammensetzung, mindestens enthaltend ein erfindungsgemäßes Polyurethan aufgebracht.

Die Auftragung kann mittels einer Lösung vorgenommen werden, es ist jedoch auch möglich, die erfindungsgemäße Beschichtungsmittelzusammensetzung oder gegebenenfalls das erfindungsgemäße Polyurethan oder ein Gemisch aus zwei oder mehr erfindungsgemäßen Polyurethanen aus einer geeigneten Extrudiervorrichtung in geschmolzenem Zustand auf dem Substrat aufzutragen. Für das aufzutragende Polyurethan ist es daher unumgänglich, daß zum einen die Lösungs- bzw. die Schmelzviskosität in einem zum Auftrag auf das Substrat geeigneten Wertebereich liegen und zum anderen die Viskosität bzw. die Härte des abgekühlten und getrockneten Films, also der photopolymerisierbaren Schicht, so hoch sind, daß auch bei längerer Lagerung oder bei üblicher Handhabung keine wesentliche Veränderung der aufgetragenen Schichtdicke stattfindet.

Die erfindungsgemäßen Beschichtungsmittelzusammensetzungen weisen deshalb vorzugsweise bei einem Feststoffanteil zwischen etwa 65% und etwa 90% in Methylethylketon eine Viskosität bis etwa maximal 12.000 mPas/25°C auf.

Die erfindungsgemäßen Polyurethane können sowohl aus organischen Lösemitteln als auch aus wäßriger Lösung aufgetragen werden. Falls eine Auftragung aus wäßriger Lösung gewünscht ist, so sind die Polyurethane vorteilhafterweise im wesentlichen selbstdispergierbar, d.h. ohne Einsatz von Dispersionshilfsmitteln in wäßriger Dispersion stabil.

Gegenstand der Erfindung ist ebenfalls ein Verfahren zur Herstellung von Polyurethanen, bei dem das Reaktionsgemisch, mindestens enthaltend
a) im wesentlichen von NCO-Gruppen freie Polyurethane mit mindestens einer olefinisch ungesättigten Doppelbindung und
b) Ammoniak oder mindestens ein primäres Amin oder mindestens ein sekundäres Amin oder ein Gemisch aus zwei oder mehr davon,
   wobei das molare Verhältnis von olefinisch ungesättigten Doppelbindungen zu aciden, von Ammoniak oder Aminen stammenden Wasserstoffatomen im Reaktionsgemisch größer als 10 : 8 ist, bei einer Temperatur von 20 bis 180°C umgesetzt und anschließend gegebenenfalls mit weiteren Zusatzstoffen vermischt wird.

Das erfindungsgemäße Verfahren kann in Lösung oder im Bulk (ohne Lösemittel) durchgeführt werden. Wenn das erfindungsgemäße Verfahren in Anwesenheit eines Lösemittels durchgeführt wird, so werden hierbei vorzugsweise nur solche Lösemittel eingesetzt, die mit keiner der im Reaktionsgemisch anwesenden funktionellen Gruppen eine Reaktion eingehen, mithin also gegenüber der Reaktionsmischung inert sind. Hierfür kommen hauptsächlich wenigstens weitgehend wassermischbare Lösemittel in Frage, die über eine ausreichende Polarität verfügen, um das Polyurethan zu lösen. Vorzugsweise sind dies Ketonlösemittel wie beispielsweise Aceton oder Methyl-Ethylketon. Ebenfalls in Frage kommen die sog. polaren aprotischen Lösemittel, wie beispielsweise N,N-Dimethylformamid (DMF), N,N-Dimethylacetamid (DMAc) oder N-Methylpyrrolidon (NMP).

Wird die Herstellung des Polyurethans ohne die o.g. Lösemittel durchgeführt, so findet die Herstellung zweckmäßigerweise bereits in einem Extruder, vorteilhafterweise in einem sog. Reaktionsextruder statt.

Bevorzugt ist bei der Umsetzung zwischen Amin und dem wenigstens eine olefinisch ungesättigte Doppelbindung enthaltenden Polyurethan noch eine weitere, gegenüber Aminen reaktive, ungesättigte Verbindung (Komponente c)) anwesend. Das molare Verhältnis der im Polyurethan gebundenen zu den nicht im Polyurethan gebundenen Doppelbindungen beträgt etwa 1:10, bevorzugt etwa 1:5 und besonders bevorzugt etwa 1:3.

Die Bedingungen für die Reaktion der Amine mit den olefinisch ungesättigte Doppelbindungen enthaltenden Polyurethanen und gegebenenfalls Verbindungen der Komponente c) werden so ausgewählt, daß nach Beendigung der Umsetzung im wesentlichen keine N-H-Gruppen mehr vorliegen. Dies bedeutet, daß die Aminzahl (Summe der primären und sekundären Aminogruppen) kleiner als 1g/100g, vorteilhafterweise weniger als 0,5g/100g und besonders vorteilhafterweise weniger als 0,2g/100g ist.

Die Umsetzung des Amins mit dem ungesättigten Polyurethan wird lösemittelfrei oder in Anwesenheit eines inerten Lösemittels durchgeführt. Dies geschieht bevorzugt bei einer Temperatur von etwa 20 bis etwa 150°C, besonders bevorzugt bei einer Temperatur von etwa 60 bis etwa 130°C und besonders bevorzugt bei einer Temperatur von etwa 80 bis etwa 120°C.

Wird die Addition des Amins in einem Reaktionsextruder durchgeführt, dann ist ein Temperaturbereich von etwa 100 bis etwa 180°C, bevorzugt etwa 120 bis etwa 150°C besonders geeignet.

Gegenstand der Erfindung ist auch die Verwendung eines erfindungsgemäßen Polyurethans oder eines Gemischs aus mehreren erfindungsgemäßen Polyurethanen oder einer erfindungsgemäßen Beschichtungsmittelzusammensetzung bei der Herstellung photopolymerisierbarer Aufzeichnungsmaterialien, insbesondere photopolymerisierbarer Druckplatten.

Ein weiterer Gegenstand der Erfindung ist damit ein photopolymerisierbares Aufzeichnungsmaterial, insbesondere eine photopolymerisierbare Druckplatte, umfassend mindestens eine Schicht, die ein erfindungsgemäßes Polyurethan oder ein Gemisch aus zwei oder mehr erfindungsgemäßen Polyurethanen enthält, oder die unter Verwendung einer erfindungsgemäßen Beschichtungsmittelzusammensetzung hergestellt wird.

Die folgenden Beispiele dienen dazu, die vorliegende Erfindung näher zu illustrieren.

### BEISPIELE

### Beispiel 1

Beispiel 3 aus der EP 584 970 wurde reproduziert. Da keine Temperaturangabe für die Zugabe des N-Methyldiethanolamins zum vorgebildeten Urethan-Prepolymeren gemacht wird, wurde das Amin bei 50°C zugegeben.
Beobachtungen: Der Ansatz gelierte innerhalb einer Stunde.

### Beispiel 2

Beispiel 3 aus der EP 584 970 wurde reproduziert, das N-Methyldiethanolamin wurde bei 20 bis 28°C zugegeben. Es wurde bei Raumtemperatur zunächst gerührt und anschließend mit Hydroxyethylmethacrylat umgesetzt.
Beobachtungen: Die Gesamtreaktionszeit betrug 34 Stunden.

### Beispiel 3

400 Tl. (0,2 mol) Polyesterdiol aus Adipinsäure, Hexandiol-1,6 und Neopentylglykol, 24,8 Tl. Ethylenglykol (0,4 mol) und 100 g MEK wurden vorgelegt. Anschließend erfolgte nach Zugabe von 148 Tl. (0,85 mol) TDI-80 eine Umsetzung für 2,5 h bei 80°C, dann, nach Zugabe von 69,7 Tl. (0,6 mol) Hydroxyethylacrylat, für weitere 11h bei 92°C und nach Zugabe von 50 g MEK, 59,5 Tl. (0,3 mol) BDA-2 und 52 Tl. (0,3 mol) Bis-1,3-(N,N'-Dimethylaminopropylamino)-2-methylpropan für weitere 6h bei 90°C.
Beobachtungen: Reaktionsdauer 19,5 h, Viskosität 9600 mPas/25°C, Feststoffanteil 76,4%.

### Beispiel 4

2000 Tl. (1 mol) Polyester (wie bei Bsp. 3), 62,1 Tl. (1 mol) Ethylenglykol und 500 Tl. MEK wurden vorgelegt. Anschließend erfolgte mit 566 Tl. (3,25 mol) TDI-80 eine Umsetzung für 2,5 h bei 80°C. Gemessener NCO-Wert 3,00% (soll, 3,36%). Anschließend wurde für 4h bei 78°C mit 348,3 Tl. (3 mol) Hydroxyethylacrylat umgesetzt (Gemessener NCO-Wert: 0%) und zum Schluß für 6h bei 90°C mit 297,3 Tl. (1,5 mol) Butandiol-1,4-diacrylat und 153,3 Tl. (1,5 mol) N,N'-Dimethyl-propandiamin. Anschließend wurde mit 50 Tl. MEK verdünnt.
Beobachtungen: Reaktionsdauer 12,5 h, Feststoffanteil 79%, Viskosität 8000 mPas/25°C, Primäramin-Zahl < 0,1 g/100 g, Sekundäramin-Zahl < 0,1 g/100 g

### Beispiel 5

2000 Tl. (1 mol) Polyesterdiol (wie bei Bsp. 3) und 500 Tl. MEK wurden vorgelegt. Anschließend erfolgte eine Umsetzung mit 821,7 Tl. (2,25 mol) Lupranat MP 102 (Oligomeres MDI der Fa. BASF AG) für 2,3 h bei 78°C bis zu einem NCO-Gehalt von 2,96% (soll 3,16 %). Darauffolgend wurde für 5h bei 79°C mit 348,3 Tl. (3 mol) Hydroxyethylacrylat umgesetzt (Gemessener NCO-Wert: 0%). Schließlich wurde mit 250 Tl. MEK verdünnt und für 6 h bei 88°C mit 297,3 Tl. (1,5 mol) BDA-2 und 153,3 Tl. (1,5 mol) N,N'-Dimethyl-1,3-propandiamin umgesetzt. Anschließend wurde mit 150 Tl. MEK verdünnt.
Beobachtungen: Reaktionsdauer 13,3 h, Viskosität 5100, Feststoffanteil 76%.

### Beispiel 6

1030 Tl. (1 mol) eines Polyesterdiols aus Adipinsäure, Isophthalsäure (Molverhältnis 1:1) und Hexandiol-1,6 und 124,1 Tl. (2 mol) Ethylenglykol wurden vorgelegt. Anschließend erfolgte eine Umsetzung mit 775 Tl. (4,45 mol) TDI-80 für 1,5 h bei 90°C, dann mit 377,1 Tl. (3,25 mol) Hydroxyethylacrylat für 6h bei 100°C.
Nach der Zugabe von 325,9 Tl. (1,1 mol) Trimethylolpropantriacrylat und 165,9 Tl. 3-(N,N-Dimethylamino)-propylamin wurde weiter für 6 h bei 90°C umgesetzt.

Das Produkt wurde warm abgefüllt.
Beobachtungen: Bei Raumtemperatur ist die Produktmasse praktisch klebfrei, Reaktionsdauer 13,5 h.

### Beispiel 7

Analog Bsp. 6, mit 1030 Tl. Polyester, 93,1 Tl. (1,5 mol) Ethylenglykol, 670,5 (3,85 mol) Tl. TDI-80, 351,1 Tl. (3 mol) Hydroxyethylacrylat und 298,7 Tl. (1 mol) TMP-Triacrylat, 92,7 Tl. (0,91 mol) 3-(N,N-Dimethylamino)-propylamin und 35,6 Tl. (0,4 mol) N-Ethyl-ethylendiamin. Die Umsetzung erfolgte bei 110°C und das Produkt wurde warm abgefüllt. Bei Raumtemperatur ist die Polyurethanmasse praktisch klebfrei.
Beobachtungen: Reaktionsdauer 13 h.

### Verarbeitung der Polyurethane zu photopolymerisierbaren Druckplatten

Die Polyurethanlösungen der Beispiele 2 - 7 wurden in einem Kolben auf 60-65°C erhitzt und 1% Benzildimethylketal als Photoinitiator zugegeben. Die Lösung wurde dann warm mittels eines Dünnschichtgießers (Gießerspalt 1500 µm) auf eine mit einer Releaseschicht versehene Polyesterfolie (Deckfolie) gegossen und drei Stunden bei 70°C vom Lösemittel (MEK) befreit. Die Schichten wurden dann kalt auf eine mit einer Haftschicht versehene Polyesterfolie (Trägerfolie) kaschiert.

### Verarbeitung der photopolymerisierbaren Druckplatte zum Klischee

Zur Belichtung wurde die Deckfolie abgezogen und ein photographisches Negativ aufgelegt. Die Platte wurde dann vollflächig in 5-Minuten-Schritten zwischen 5 und 20 Minuten mit UV-Licht der Wellenlänge 366 nm bestrahlt. Das Negativ wurde entfernt und die Platte bei 30°C in 5%-iger wäßriger Milchsäure bzw. 1%iger wäßriger Zitronensäure in einem Reibewascher ausgewaschen. Anschließend wurde die so enthaltenen Klischees im Umlufttrockenschrank bei 70°C eine Stunde getrocknet.

### Beurteilung der erhaltenen Klischees

Insbesondere die Beispiele 5-7, besonders Beispiel 6, lieferten exakte Kopien der verwendeten Negative und auch kleinste Elemente (Raster mit 1% Flächendeckung) konnten ohne Schwierigkeiten reproduziert werden. Die geringe Quellung der Beispiele 6 und 7 in Wasser macht diese Klischees auch brauchbar für den Druck mit Wasserfarben. Beispiele 3 und 4 zeigten sich bezüglich der Harte des Klischees Beispiel 2 (Vergleich) überlegen bzw. ebenbürtig, trotz einer deutlich geringeren Reaktionszeit bei der Herstellung.

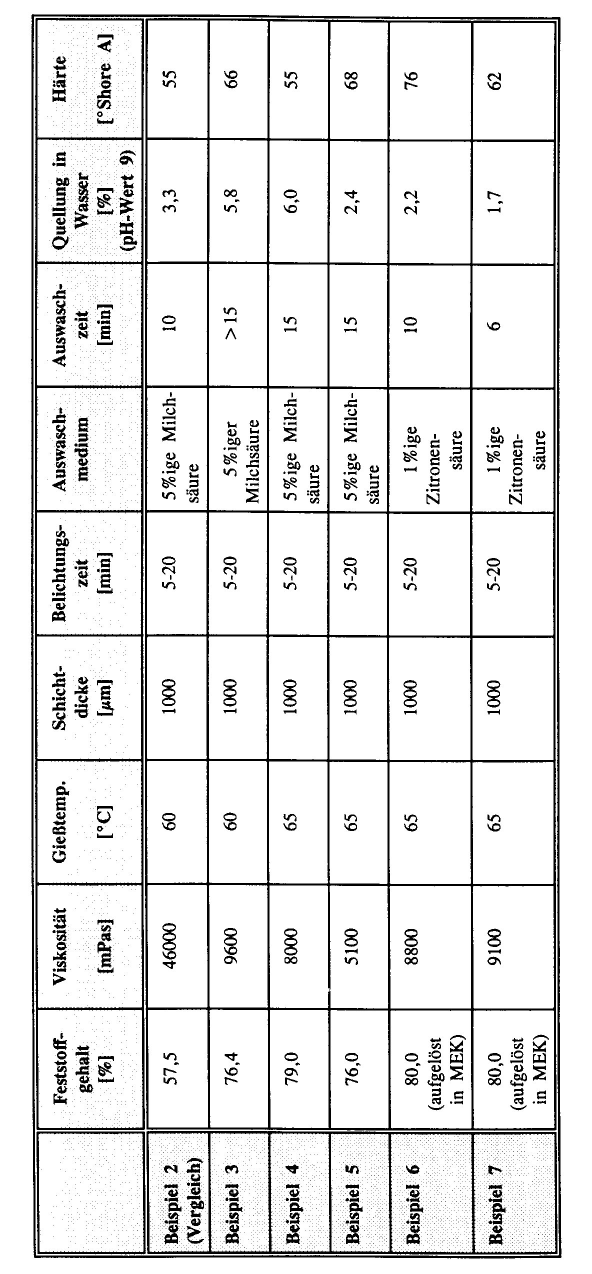

## Patentansprüche

1. Polyurethan, erhältlich durch Umsetzung eines Reaktionsgemischs mindestens enthaltend
a) ein im wesentlichen von NCO-Gruppen freies Polyurethan mit mindestens einer olefinisch ungesättigten Doppelbindung und
b) Ammoniak oder mindestens ein primäres Amin oder mindestens ein sekundäres Amin oder ein Gemisch aus zwei oder mehr davon,
dadurch gekennzeichnet, daß das molare Verhältnis von olefinisch ungesättigten Doppelbindungen zu aciden, von Ammoniak oder Aminen stammenden Wasserstoffatomen im Reaktionsgemisch größer als 10 : 8 ist.

2. Polyurethan nach Anspruch 1, dadurch gekennzeichnet, daß bei der Umsetzung zusätzlich
c) mindestens eine von Urethangruppen freie Verbindung mit mindestens einer olefinisch ungesättigten Doppelbindung
vorliegt.

3. Polyurethane nach Anspruch 1 oder 2, dadurch gekennzeichnet, daß als Komponente b) ein primäres oder sekundäres Amin oder ein Gemisch aus zwei oder mehr davon eingesetzt wird.

4. Polyurethan nach einem der vorstehenden Ansprüche, dadurch gekennzeichnet, daß das molare Verhältnis von olefinisch ungesättigten Doppelbindungen zu aciden, vom Ammoniak oder den Aminen stammenden Wasserstoffatomen von 10:7 bis 10:2, bevorzugt von 10:7 bis 10:3 beträgt.

5. Polyurethan nach einem der vorstehenden Ansprüche, dadurch gekennzeichnet, daß es in Wasser im wesentlichen selbstdispergierbar ist.

6. Verfahren zur Herstellung eines Polyurethans, wobei ein Reaktionsgemisch, mindestens enthaltend
a) ein im wesentlichen von NCO-Gruppen freies Polyurethan mit mindestens einer olefinisch ungesättigten Doppelbindung und
b) Ammoniak oder mindestens ein primäres Amin oder mindestens ein sekundäres Amin oder ein Gemisch aus zwei oder mehr davon,
bei einer Temperatur von 20 bis 180°C umgesetzt wird,
dadurch gekennzeichnet, daß das molare Verhältnis von olefinisch ungesättigten Doppelbindungen zu aciden, von Ammoniak oder Aminen stammenden Wasserstoffatomen im Reaktionsgemisch größer als 10 : 8 ist.

7. Verwendung eines Polyurethans oder eines Gemischs aus zwei oder mehr Polyurethanen gemäß einem der Ansprüche 1 bis 5 oder hergestellt gemäß Anspruch 6, in Beschichtungsmittelzusammensetzungen.

8. Beschichtungsmittelzusammensetzung, enthaltend ein Polyurethan oder ein Gemisch aus zwei oder mehr Polyurethanen gemäß einem der Ansprüche 1 bis 5 oder hergestellt gemäß Anspruch 6.

9. Verwendung eines Polyurethans oder eines Gemischs aus zwei oder mehr Polyurethanen gemäß einem der Ansprüche 1 bis 5 oder hergestellt gemäß Anspruch 6 oder einer Beschichtungsmittelzusammensetzung gemäß Anspruch 8 oder 9 bei der Herstellung photopolymerisierbarer Aufzeichnungsmaterialien.

10. Photopolymerisierbare Druckplatte, umfassend mindestens eine Schicht, die ein Polyurethan oder ein Gemisch aus zwei oder mehr Polyurethanen gemäß einem der Ansprüche 1 bis 5 oder hergestellt gemäß Anspruch 6 enthält, oder die unter Verwendung einer Beschichtungsmittelzusammensetzung gemäß einem der Ansprüche 8 oder 9 hergestellt wird.
